(19) Europäisches Patentamt
European Patent Office
Office européen des brevets

(11) **EP 3 133 850 A1**

(12) **EUROPEAN PATENT APPLICATION**
published in accordance with Art. 153(4) EPC

(43) Date of publication:
**22.02.2017 Bulletin 2017/08**

(51) Int Cl.:
***H04W 8/22*** (2009.01)

(21) Application number: **14891091.2**

(22) Date of filing: **30.04.2014**

(86) International application number:
**PCT/CN2014/076688**

(87) International publication number:
**WO 2015/165118 (05.11.2015 Gazette 2015/44)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Huawei Technologies Co. Ltd.**
**Shenzhen, Guangdong 518129 (CN)**

(72) Inventors:
- **RAO, Xiongbin**
  **Shenzhen**
  **Guangdong 518129 (CN)**
- **LAU, Kin Nang**
  **Shenzhen**
  **Guangdong 518129 (CN)**
- **KONG, Xiangming**
  **Shenzhen**
  **Guangdong 518129 (CN)**

(74) Representative: **Maiwald Patentanwalts GmbH**
**Engineering**
**Elisenhof**
**Elisenstrasse 3**
**80335 München (DE)**

(54) **COMPRESSED SENSING METHOD AND DEVICE**

(57) Embodiments of the present invention relate to the wireless communications field and provide a compressed sensing method and an apparatus, which can reduce costs of capturing a sparse signal. The method includes: receiving observed data sent by at least two receivers, where the observed data is data that is obtained through sampling performed by the at least two receivers on sparse signals of the at least two receivers according to observation matrices of the at least two receivers; determining a shared support set according to the observed data and a joint sparse feature, where the joint sparse feature is that a sparse signal of each receiver includes at least one support set and at least one shared support set exists between the sparse signals of the at least two receivers, where the shared support set is a support set shared between the sparse signals of the at least two receivers; determining a support set of each sparse signal according to the shared support set and the joint sparse feature; and determining each sparse signal according to the shared support set and the support set of each sparse signal.

A data processing center receives observed data sent by at least two receivers, where the observed data is data that is obtained through sampling performed by the at least two receivers on target signals of the at least two receivers according to observation matrices of the at least two receivers, and the target signals are sparse signals — S101

The data processing center determines a shared support set according to the received observed data and a joint sparse feature — S102

The data processing center determines a support set of each sparse signal according to the shared support set and the joint sparse feature — S103

The data processing center determines each sparse signal according to the shared support set and the support set of each sparse signal — S104

FIG. 6

EP 3 133 850 A1

## Description

## TECHNICAL FIELD

The present invention relates to the wireless communications field, and in particular, to a compressed sensing method and an apparatus.

## BACKGROUND

With the increase of dimensions in a wireless communications system, it is extraordinarily difficult to acquire a high-dimensional target signal (a signal that needs to be captured and recovered in a wireless network) in the communications system. For example, if conventional ADC (Analog-to-Digital Converter, analog-to-digital converter) sampling is used for an ultra wideband signal in the wireless communications system, a sampling rate of the ADC needs to linearly increase together with signal frequency bandwidth to implement lossless sampling. Due to limitation of manufacturing crafts, hardware costs of a high-rate ADC are quite high, and hardware costs of ultra-wideband wireless communications sharply increase because of usage of the conventional ADC sampling technology. In addition, in a conventional method for acquiring CSIT (Channel State Information at The Transmitters, channel state information at the transmitters) in a FDD (Frequency Division Duplex, frequency division duplex) wireless communications system of massive MIMO, a length of a training sequence sent by a BS (Base Station, base station) side is required to increase linearly together with a quantity of antennas on the BS side, which results in considerably large training sequence overheads on the BS side, and greatly decreases a spatial multiplexing gain, a diversity gain, and the like that can be brought by the massive MIMO.

In addition, with the continuous increase of a dimension of a target signal in the wireless communications system, the target signal generally presents a sparse feature. For example, in an ultra wideband communications system, due to a burst transmission feature of some applications (for a voice service of a mobile user, the user has much idle time), a signal frequency band may be sparsely utilized. In addition, because of a shareable attribute of a wireless transmission environment, a quite strong association feature is usually presented inside target signals and between the target signals, that is, the target signals usually present a joint sparse feature. For example, in a MIMO (Multiple Input Multiple Output, multiple input multiple output) communications system of a distributed antenna, all active users observed by using antennas at a same station are the same, and some active users observed at different stations may be the same. With respect to a sparse feature of a target signal, a CS (Compressed Sensing, compressed sensing; or Compressive Sampling, compressive sampling) theory has been proposed at present. It is proposed in the theory that, when a target signal presents a sparse feature, the target signal can be effectively recovered only by using a small quantity of sampled values or a small amount of observed data. Currently, there are already some technical methods in which the CS theory is introduced to the wireless communications system. However, in these technical methods, usually, only a point-to-point system is considered and the most direct introduction method is used; therefore, costs of acquiring a high-dimensional target signal (sparse signal) are still relatively high.

## SUMMARY

Embodiments of the present invention provide a compressed sensing method and an apparatus, so as to resolve a problem that costs of capturing a high-dimensional target signal in an existing wireless communications system are relatively high.

To achieve the foregoing objective, the following technical solutions are used in the embodiments of the present invention:

According to a first aspect, an embodiment of the present invention provides a data processing center, including:

a receiving unit, configured to receive observed data sent by at least two receivers, where the observed data is data that is obtained through sampling performed by the at least two receivers on sparse signals of the at least two receivers according to observation matrices of the at least two receivers; and
a determining unit, configured to: determine a shared support set according to the observed data received by the receiving unit and a joint sparse feature, where the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver; configured to determine a support set of each sparse signal according to the shared support set and the joint sparse feature; and configured to determine each sparse signal according to the shared support set and the support set of each sparse signal.

In a first possible implementation manner of the first aspect, that the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;

the sparse signals of the at least two receivers have at least one shared support set in the two-dimensional matrix, where the shared support set is a shared non-zero row index set of the sparse signals of the at least two receivers in the two-dimensional matrix; and

the sparse signal of each receiver has at least one support set in the two-dimensional matrix, where the support set is an index set that none of row vectors of a same row in the two-dimensional matrix of the sparse signals of the receivers is zero.

In a second possible implementation manner of the first aspect, the at least two receivers obtain the observed data by performing sampling on the sparse signals of the at least two receivers by using the following formula:

$$Y_i = \Phi_i X_i + N_i \qquad i = 1, \cdots K,$$

where $K$ is a quantity of receivers, and $K \geq 2$; $X_i$ is a sparse signal of the ith receiver; $Y_i$ is observed data of $X_i$; $\Phi_i$ is an observation matrix of the ith receiver; $N_i$ is observation noise of the ith receiver; $X_i \in C^{M \times N}$ is a matrix with $M$ rows and $N$ columns, where $N$ is a quantity of antennas included in the ith receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the ith receiver; $\Phi_i \in C^{T \times M}$ is a matrix with $T$ rows and $M$ columns; and $N_i \in C^{N \times T}$ is a matrix with $N$ rows and $T$ columns.

According to a second aspect, an embodiment of the present invention provides a receiver, including:

an acquiring unit, configured to acquire observed data of a first receiver, where the observed data is data that is obtained through sampling performed by the first receiver on a sparse signal of the first receiver according to an observation matrix of the first receiver; and

a determining unit, configured to: determine a shared support set according to a joint sparse feature and the observed data acquired by the acquiring unit, where the joint sparse feature is that a sparse signal of each receiver of at least two receivers includes at least one support set and at least one shared support set exists between sparse signals of the at least two receivers, where the shared support set is a support set shared between the sparse signals of the at least two receivers, the support set is a non-zero row index set in a matrix of the sparse signal of each receiver, and a backhaul connection is supported between the first receiver and the second receiver; configured to determine a support set of the sparse signal of the first receiver according to the shared support set and the joint sparse feature; and configured to determine the sparse signal of the first receiver according to the shared support set and the support set of the sparse signal of the first receiver.

In a first possible implementation manner of the second aspect, that the joint sparse feature is that a sparse signal of each receiver of at least two receivers includes at least one support set and at least one shared support set exists between sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;

the sparse signals of the at least two receivers have at least one shared support set in the two-dimensional matrix, where the shared support set is a shared non-zero row index set of the sparse signals of the at least two receivers in the two-dimensional matrix; and

the sparse signal of each receiver has at least one support set in the two-dimensional matrix, where the support set is an index set that none of row vectors of a same row in the two-dimensional matrix of the sparse signals of the receivers is zero.

With reference to the first possible implementation manner of the second aspect, in a second possible implementation manner of the first aspect, the determining unit is specifically configured to: determine an estimated support set of the sparse signal of the first receiver according to the joint sparse feature and the observed data, and is specifically configured to interchange the estimated support set with an estimated support set of the second receiver, and determine the shared support set according to the joint sparse feature, where the second receiver is another receiver that is in the at least two receivers other than the first receiver and that supports a backhaul connection to the first receiver.

In a third possible implementation manner of the first aspect, the first receiver obtains the observed data by performing sampling on the sparse signal of the first receiver by using the following formula:

$$Y_i = \Phi_i X_i + N_i \qquad i = 1, \cdots K ,$$

where $K$ is a quantity of receivers, and $K \geq 2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$ rows and $N$ columns, where $N$ is a quantity of antennas included in the $i^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the $i^{th}$ receiver; $\Phi_i \in C^{T \times M}$ is a matrix with $T$ rows and $M$ columns; and $N_i \in C^{N \times T}$ is a matrix with $N$ rows and $T$ columns.

According to a third aspect, an embodiment of the present invention provides a data processing center, including:

a receiver, configured to receive observed data sent by at least two receivers, where the observed data is data that is obtained through sampling performed by the at least two receivers on sparse signals of the at least two receivers according to observation matrices of the at least two receivers; and
a processor, configured to: determine a shared support set according to the observed data received by the receiver and a joint sparse feature, where the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver; configured to determine a support set of each sparse signal according to the shared support set and the joint sparse feature; and configured to determine each sparse signal according to the shared support set and the support set of each sparse signal.

In a first possible implementation manner of the third aspect, that the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;
the sparse signals of the at least two receivers have at least one shared support set in the two-dimensional matrix, where the shared support set is a shared non-zero row index set of the sparse signals of the at least two receivers in the two-dimensional matrix; and
the sparse signal of each receiver has at least one support set in the two-dimensional matrix, where the support set is an index set that none of row vectors of a same row in the two-dimensional matrix of the sparse signals of the receivers is zero.

In a second possible implementation manner of the third aspect, the at least two receivers obtain the observed data by performing sampling on the sparse signals of the at least two receivers by using the following formula:

$$Y_i = \Phi_i X_i + N_i \qquad i = 1, \cdots K ,$$

where $K$ is a quantity of receivers, and $K \geq 2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$ rows and $N$ columns, where $N$ is a quantity of antennas included in the $i^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the $i^{th}$ receiver; $\Phi_i \in C^{T \times M}$ is a matrix with $T$ rows and $M$ columns; and $N_i \in C^{N \times T}$ is a matrix with $N$ rows and $T$ columns.

With reference to the third aspect or either one of the first possible implementation manner and the second possible implementation manner of the third aspect, in a third possible implementation manner of the third aspect, the data processing center includes a central processing unit.

According to a fourth aspect, an embodiment of the present invention provides a receiver, including:

a processor, configured to: acquire observed data of a first receiver, where the observed data is data that is obtained through sampling performed by the first receiver on a sparse signal of the first receiver according to an observation matrix of the first receiver; configured to determine a shared support set according to a joint sparse feature and the acquired observed data, where the joint sparse feature is that a sparse signal of each receiver of at least two receivers includes at least one support set and at least one shared support set exists between sparse signals of the at least two receivers, where the shared support set is a support set shared between the sparse signals of the at least two receivers, the support set is a non-zero row index set in a matrix of the sparse signal of each receiver, and a backhaul connection is supported between the first receiver and the second receiver; configured to determine a support set of the sparse signal of the first receiver according to the shared support set and the joint sparse feature; and configured to determine the sparse signal of the first receiver according to the shared support set and the support set of the sparse signal of the first receiver.

In a first possible implementation manner of the fourth aspect, that the joint sparse feature is that a sparse signal of each receiver of at least two receivers includes at least one support set and at least one shared support set exists between sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;
the sparse signals of the at least two receivers have at least one shared support set in the two-dimensional matrix, where the shared support set is a shared non-zero row index set of the sparse signals of the at least two receivers in the two-dimensional matrix; and
the sparse signal of each receiver has at least one support set in the two-dimensional matrix, where the support set is an index set that none of row vectors of a same row in the two-dimensional matrix of the sparse signals of the receivers is zero.

With reference to the first possible implementation manner of the fourth aspect, in a second possible implementation manner of the fourth aspect, the processor is specifically configured to: determine an estimated support set of the sparse signal of the first receiver according to the joint sparse feature and the observed data, and is specifically configured to interchange the estimated support set with an estimated support set of the second receiver, and determine the shared support set according to the joint sparse feature, where the second receiver is another receiver that is in the at least two receivers other than the first receiver and that supports a backhaul connection to the first receiver.
In a third possible implementation manner of the fourth aspect, the first receiver obtains the observed data by performing sampling on the sparse signal of the first receiver by using the following formula:

$$Y_i = \Phi_i X_i + N_i \qquad i = 1, \cdots K,$$

where $K$ is a quantity of receivers, and $K \geq 2$; $X_i$ is a sparse signal of the ith receiver; $Y_i$ is observed data of $X_i$; $\Phi_i$ is an observation matrix of the ith receiver; $N_i$ is observation noise of the ith receiver; $X_i \in C^{M \times N}$ is a matrix with M rows and $N$ columns, where $N$ is a quantity of antennas included in the ith receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the ith receiver; $\Phi_i \in C^{T \times M}$ is a matrix with $T$ rows and $M$ columns; and $N_i \in C^{N \times T}$ is a matrix with $N$ rows and $T$ columns.
With reference to the fourth aspect or any one of the first possible implementation manner to the third possible implementation manner of the fourth aspect, in a fourth possible implementation manner of the fourth aspect, the receiver includes a base station or a base station controller.
According to a fifth aspect, an embodiment of the present invention provides a compressed sensing method, including:

receiving observed data sent by at least two receivers, where the observed data is data that is obtained through sampling performed by the at least two receivers on sparse signals of the at least two receivers according to observation matrices of the at least two receivers;
determining a shared support set according to the received observed data and a joint sparse feature, where the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver;
determining a support set of each sparse signal according to the shared support set and the joint sparse feature; and
determining each sparse signal according to the shared support set and the support set of each sparse signal.

In a first possible implementation manner of the fifth aspect, that the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;

the sparse signals of the at least two receivers have at least one shared support set in the two-dimensional matrix, where the shared support set is a shared non-zero row index set of the sparse signals of the at least two receivers in the two-dimensional matrix; and

the sparse signal of each receiver has at least one support set in the two-dimensional matrix, where the support set is an index set that none of row vectors of a same row in the two-dimensional matrix of the sparse signals of the receivers is zero.

In a second possible implementation manner of the fifth aspect, the at least two receivers obtain the observed data by performing sampling on the sparse signals of the at least two receivers by using the following formula:

$$Y_i = \Phi_i X_i + N_i \qquad i = 1, \cdots K,$$

where $K$ is a quantity of receivers, and $K \geq 2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$ rows and $N$ columns, where $N$ is a quantity of antennas included in the $i^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the $i^{th}$ receiver; $\Phi_i \in C^{T \times M}$ is a matrix with $T$ rows and $M$ columns; and $N_i \in C^{N \times T}$ is a matrix with $N$ rows and $T$ columns.

According to a sixth aspect, an embodiment of the present invention provides a compressed sensing method, including:

acquiring observed data of a first receiver, where the observed data is data that is obtained through sampling performed by the first receiver on a sparse signal of the first receiver according to an observation matrix of the first receiver;

determining a shared support set according to a joint sparse feature and the observed data, where the joint sparse feature is that a sparse signal of each receiver of at least two receivers includes at least one support set and at least one shared support set exists between sparse signals of the at least two receivers, where the shared support set is a support set shared between the sparse signals of the at least two receivers, the support set is a non-zero row index set in a matrix of the sparse signal of each receiver, and a backhaul connection is supported between the first receiver and the second receiver;

determining a support set of the sparse signal of the first receiver according to the shared support set and the joint sparse feature; and

determining the sparse signal of the first receiver according to the shared support set and the support set of the sparse signal of the first receiver.

In a first possible implementation manner of the sixth aspect, that the joint sparse feature is that a sparse signal of each receiver of at least two receivers includes at least one support set and at least one shared support set exists between sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;

the sparse signals of the at least two receivers have at least one shared support set in the two-dimensional matrix, where the shared support set is a shared non-zero row index set of the sparse signals of the at least two receivers in the two-dimensional matrix; and

the sparse signal of each receiver has at least one support set in the two-dimensional matrix, where the support set is an index set that none of row vectors of a same row in the two-dimensional matrix of the sparse signals of the receivers is zero.

With reference to the first possible implementation manner of the sixth aspect, in a second possible implementation manner of the sixth aspect, the determining a shared support set according to a joint sparse feature and the observed data specifically includes:

determining an estimated support set of the sparse signal of the first receiver according to the joint sparse feature and the observed data; and

interchanging the estimated support set with an estimated support set of the second receiver, and determining the shared support set according to the joint sparse feature, where the second receiver is another receiver that is in the at least two receivers other than the first receiver and that supports a backhaul connection to the first receiver.

In a third possible implementation manner of the sixth aspect, the first receiver obtains the observed data by performing sampling on the sparse signal of the first receiver by using the following formula:

$$Y_i = \Phi_i X_i + N_i \qquad i = 1, \cdots K,$$

where $K$ is a quantity of receivers, and $K{\geq}2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$ rows and $N$ columns, where $N$ is a quantity of antennas included in the $i^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the $i^{th}$ receiver; $\Phi_i \in C^{T \times M}$ is a matrix with $T$ rows and $M$ columns; and $N_i \in C^{N \times T}$ is a matrix with $N$ rows and $T$ columns.

The embodiments of the present invention provide a compressed sensing method. After a data processing center receives observed data sent by at least one receiver, the data processing center determines a shared support set according to all observed data and a joint sparse feature; after determining the shared support set, the data processing center determines a support set of each sparse signal according to the shared support set and the joint sparse feature; and finally, the data processing center determines each sparse signal according to the shared support set and the support set of each sparse signal, where the observed data is data that is obtained through sampling performed by each receiver on a sparse signal of the receiver according to an observation matrix of the receiver, and the joint sparse feature is that a shared support set exists between all sparse signals and at least one support set exists inside each sparse signal, where the support set is a non-zero row index set in a matrix corresponding to each sparse signal, and a non-zero row is a row whose row vector is not zero in the matrix. In the solution, a joint sparse feature inside sparse signals and between the sparse signals is utilized in the present invention, which resolves a problem that costs of capturing a sparse signal are relatively high in an existing wireless communications system, and reduces the costs of capturing a sparse signal.

**BRIEF DESCRIPTION OF DRAWINGS**

To describe the technical solutions in the embodiments of the present invention or in the prior art more clearly, the following briefly describes the accompanying drawings required for describing the embodiments or the prior art. Apparently, the accompanying drawings in the following description show merely some embodiments of the present invention, and a person of ordinary skill in the art may still derive other drawings from these accompanying drawings without creative efforts.

FIG. 1 is a first schematic structural diagram of a data processing center according to an embodiment of the present invention;
FIG. 2 is a first schematic structural diagram of a receiver according to an embodiment of the present invention;
FIG. 3 is a second schematic structural diagram of a data processing center according to an embodiment of the present invention;
FIG. 4 is a second schematic structural diagram of a receiver according to an embodiment of the present invention;
FIG. 5 is a first application scenario diagram of a compressed sensing method according to an embodiment of the present invention;
FIG. 6 is a first schematic flowchart of a compressed sensing method according to an embodiment of the present invention;
FIG. 7 is a first schematic structural diagram of a joint sparse feature according to an embodiment of the present invention;
FIG. 8 is a second schematic structural diagram of a joint sparse feature according to an embodiment of the present invention;
FIG. 9 is a second application scenario diagram of a compressed sensing method according to an embodiment of the present invention; and
FIG. 10 is a second schematic flowchart of a compressed sensing method according to an embodiment of the present invention.

**DESCRIPTION OF EMBODIMENTS**

The following clearly and completely describes the technical solutions in the embodiments of the present invention with reference to the accompanying drawings in the embodiments of the present invention. Apparently, the described embodiments are merely some but not all of the embodiments of the present invention. All other embodiments obtained by a person of ordinary skill in the art based on the embodiments of the present invention without creative efforts shall fall within the protection scope of the present invention.

Technologies described in this specification may be applied to various wireless communications systems, for example, a Global System for Mobile Communications (GSM, global system for mobile communications), a Code Division Multiple Access (CDMA, code division multiple access) system, a Time Division Multiple Access (TDMA, time division multiple access) system, a Wideband Code Division Multiple Access (WCDMA, wideband code division multiple access wireless) system, a Frequency Division Multiple Access (FDMA, frequency division multiple addressing) system, an Orthogonal Frequency-Division Multiple Access (OFDMA, orthogonal frequency-division multiple access) system, a single-carrier FDMA (SC-FDMA) system, a General Packet Radio Service (GPRS, general packet radio service) system, a Long Term Evolution (LTE, long term evolution) system, and other communications systems of these types.

In the technical solutions of the present invention, a framework of signal capture in a wireless communications system is considered. The technical framework may involve many specific application issues, for example, the technical framework may be applied to an issue of analog-to-information conversion of a distributed RF (Radio Frequency, RF) part, and an issue of acquiring CSIT in a multi-user massive MIMO network.

**Embodiment 1**

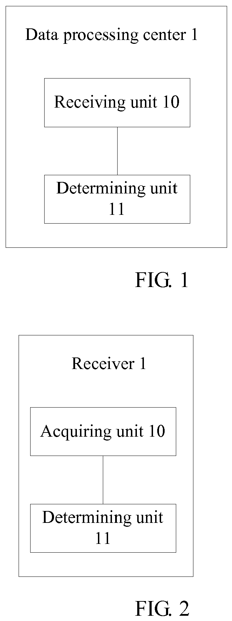

This embodiment of the present invention provides a data processing center 1. As shown in FIG. 1, the data processing center 1 includes:

a receiving unit 10, configured to receive observed data sent by at least two receivers, where the observed data is data that is obtained through sampling performed by the at least two receivers on sparse signals of the at least two receivers according to observation matrices of the at least two receivers; and
a determining unit 11, configured to: determine a shared support set according to the observed data received by the receiving unit 10 and a joint sparse feature, where the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver; configured to determine a support set of each sparse signal according to the shared support set and the joint sparse feature; and configured to determine each sparse signal according to the shared support set and the support set of each sparse signal.

Further, that the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;

the sparse signals of the at least two receivers have at least one shared support set in the two-dimensional matrix, where the shared support set is a shared non-zero row index set of the sparse signals of the at least two receivers in the two-dimensional matrix; and

the sparse signal of each receiver has at least one support set in the two-dimensional matrix, where the support set is an index set that none of row vectors of a same row in the two-dimensional matrix of the sparse signals of the receivers is zero.

Further, the at least two receivers obtain the observed data by performing sampling on the sparse signals of the at least two receivers by using the following formula:

$$Y_\mathrm{i} = \Phi_\mathrm{i} X_\mathrm{i} + N_\mathrm{i} \qquad \mathrm{i} = 1, \cdots K,$$

where $K$ is a quantity of receivers, and $K \geq 2$; $X_i$ is a sparse signal of the $i^\mathrm{th}$ receiver; $Y_i$ is observed data of $X_i$; $\Phi_i$ is an observation matrix of the $i^\mathrm{th}$ receiver; $N_i$ is observation noise of the $i^\mathrm{th}$ receiver; $X_i \in C^{M \times N}$ is a matrix with $M$ rows and $N$ columns, where $N$ is a quantity of antennas included in the $i^\mathrm{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the $i^\mathrm{th}$ receiver; $\Phi_i \in C^{T \times M}$ is a matrix with $T$ rows and $M$ columns; and $N_i \in C^{N \times T}$ is a matrix with $N$ rows and $T$ columns.

This embodiment of the present invention provides a data processing center that mainly includes a receiving unit and a processing unit. After the data processing center receives observed data sent by at least one receiver, the data processing center determines a shared support set according to all observed data and a joint sparse feature; after determining the shared support set, the data processing center determines a support set of each sparse signal according to the shared support set and the joint sparse feature; and finally, the data processing center determines each sparse signal according to the shared support set and the support set of each sparse signal, where the observed data is data that is obtained through sampling performed by each receiver on a sparse signal of the receiver according to an observation matrix of the receiver, and the joint sparse feature is that a shared support set exists between all sparse signals and at least one support set exists inside each sparse signal, where the support set is a non-zero row index set in a matrix corresponding to each sparse signal, and a non-zero row is a row whose row vector is not zero in the matrix. In the solution, a joint sparse feature inside sparse signals and between the sparse signals is utilized in the present invention, which resolves a problem that costs of capturing a sparse signal are relatively high in an existing wireless communications system, and reduces the costs of capturing a sparse signal.

**Embodiment 2**

This embodiment of the present invention provides a receiver 1. As shown in FIG. 2, the receiver 1 includes:

an acquiring unit 10, configured to acquire observed data of a first receiver, where the observed data is data that is obtained through sampling performed by the first receiver on a sparse signal of the first receiver according to an observation matrix of the first receiver; and
a determining unit 11, configured to: determine a shared support set according to a joint sparse feature and the observed data acquired by the acquiring unit 10, where the joint sparse feature is that a sparse signal of each receiver of at least two receivers includes at least one support set and at least one shared support set exists between sparse signals of the at least two receivers, where the shared support set is a support set shared between the sparse signals of the at least two receivers, the support set is a non-zero row index set in a matrix of the sparse signal of each receiver, and a backhaul connection is supported between the first receiver and the second receiver; configured to determine a support set of the sparse signal of the first receiver according to the shared support set and the joint sparse feature; and configured to determine the sparse signal of the first receiver according to the shared support set and the support set of the sparse signal of the first receiver.

Further, that the joint sparse feature is that a sparse signal of each receiver of at least two receivers includes at least one support set and at least one shared support set exists between sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;
the sparse signals of the at least two receivers have at least one shared support set in the two-dimensional matrix, where the shared support set is a shared non-zero row index set of the sparse signals of the at least two receivers in the two-dimensional matrix; and
the sparse signal of each receiver has at least one support set in the two-dimensional matrix, where the support set is an index set that none of row vectors of a same row in the two-dimensional matrix of the sparse signals of the receivers is zero.

Further, the determining unit 11 is specifically configured to: determine an estimated support set of the sparse signal of the first receiver according to the joint sparse feature and the observed data, and is specifically configured to interchange the estimated support set with an estimated support set of the second receiver, and determine the shared support set according to the joint sparse feature, where the second receiver is another receiver that is in the at least two receivers other than the first receiver and that supports a backhaul connection to the first receiver.

Further, the first receiver obtains the observed data by performing sampling on the sparse signal of the first receiver by using the following formula:

$$Y_i = \Phi_i X_i + N_i \qquad i = 1, \cdots K,$$

where $K$ is a quantity of receivers, and $K \geq 2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$ rows and $N$ columns, where $N$ is a quantity of antennas included in the $i^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the $i^{th}$ receiver; $\Phi_i \in C^{T \times M}$ is a matrix with $T$ rows and $M$ columns; and $N_i \in C^{N \times T}$ is a matrix with $N$ rows and $T$ columns.

This embodiment of the present invention provides a receiver that mainly includes an acquiring unit and a determining unit. After acquiring observed data of the receiver, the receiver determines a shared support set according to a joint sparse feature and the observed data of the receiver; then, the receiver determines a support set of a sparse signal of the receiver according to the shared support set and the joint sparse feature; and finally, the receiver determines a sparse signal of a first receiver according to the shared support set and the support set of the sparse signal of the receiver, where the observed data is data that is obtained through sampling performed on the sparse signal of the receiver according to an observation matrix of the receiver, and the joint sparse feature is that a shared support set exists between all sparse signals and at least one support set exists inside each sparse signal, where the support set is a non-zero row index set in a matrix corresponding to each sparse signal, and a non-zero row is a row whose row vector is not zero in the matrix. In the solution, a joint sparse feature inside sparse signals and between the sparse signals is utilized in the present invention, which resolves a problem that costs of capturing a high-dimensional sparse signal are relatively high in an existing wireless communications system, and reduces the costs of capturing a sparse signal.

**Embodiment 3**

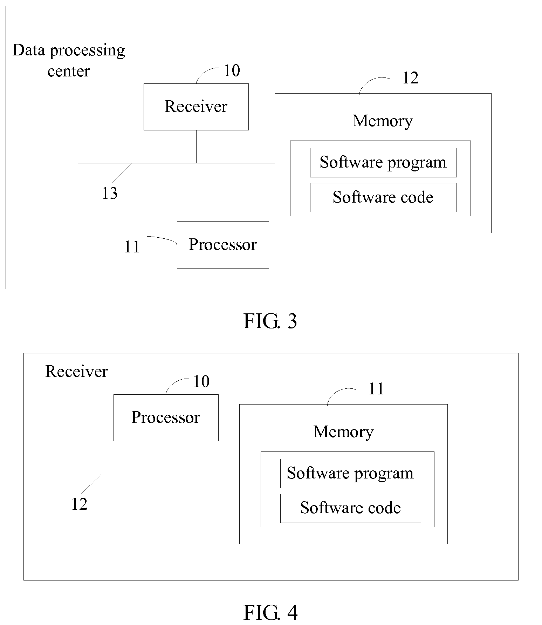

This embodiment of the present invention provides a data processing center. As shown in FIG. 3, the data processing center may include a receiver 10, a processor 11, a memory 12, and a system bus 13.

The receiver 10, the processor 11, and the memory 12 are connected and implement mutual communication by using the system bus 13.

The processor 11 may be a single-core or multi-core central processing unit, an application-specific integrated circuit, or the processor 11 may be configured to be one or more integrated circuits of this embodiment of the present invention.

The memory 12 may be a high-speed RAM (Random Access Memory, random access memory) memory, or a non-volatile memory (non-volatile memory), for example, at least one magnetic disk storage.

The memory 12 is configured to store an execution instruction of the data processing center. Specifically, the execution instruction of the data processing center may include a software program and software code.

Specifically, the receiver 10 is configured to receive observed data sent by at least two receivers, where the observed data is data that is obtained through sampling performed by the at least two receivers on sparse signals of the at least two receivers according to observation matrices of the at least two receivers.

The processor 11 is configured to: determine a shared support set according to the observed data received by the receiver 10 and a joint sparse feature, where the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver; configured to determine a support set of each sparse signal according to the shared support set and the joint sparse feature; and configured to determine each sparse signal according to the shared support set and the support set of each sparse signal.

Further, that the joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;
the sparse signals of the at least two receivers have at least one shared support set in the two-dimensional matrix, where the shared support set is a shared non-zero row index set of the sparse signals of the at least two receivers in the two-dimensional matrix; and
the sparse signal of each receiver has at least one support set in the two-dimensional matrix, where the support set is an index set that none of row vectors of a same row in the two-dimensional matrix of the sparse signals of the receivers is zero.

Further, the at least two receivers obtain the observed data by performing sampling on the sparse signals of the at least two receivers by using the following formula:

$$Y_i = \Phi_i X_i + N_i \qquad i = 1, \cdots K,$$

where $K$ is a quantity of receivers, and $K \geq 2$; $X_i$ is a sparse signal of the ith receiver; $Y_i$ is observed data of $X_i$; $\Phi_i$ is an observation matrix of the ith receiver; $N_i$ is observation noise of the ith receiver; $X_i \in C^{M \times N}$ is a matrix with $M$ rows and $N$ columns, where $N$ is a quantity of antennas included in the ith receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the ith receiver; $\Phi_i \in C^{T \times M}$ is a matrix with $T$ rows and $M$ columns; and $N_i \in C^{N \times T}$ is a matrix with $N$ rows and $T$ columns.

Specifically, the data processing center may be a central processing unit, which is not limited in this embodiment of the present invention.

This embodiment of the present invention provides a data processing center. After the data processing center receives observed data sent by at least one receiver, the data processing center determines a shared support set according to all observed data and a joint sparse feature; after determining the shared support set, the data processing center determines a support set of each sparse signal according to the shared support set and the joint sparse feature; and finally, the data processing center determines each sparse signal according to the shared support set and the support set of each sparse signal, where the observed data is data that is obtained through sampling performed by each receiver on a sparse signal of the receiver according to an observation matrix of the receiver, and the joint sparse feature is that a shared support set exists between all sparse signals and at least one support set exists inside each sparse signal, where the support set is a non-zero row index set in a matrix corresponding to each sparse signal, and a non-zero row is a row whose row vector is not zero in the matrix. In the solution, a joint sparse feature inside sparse signals and between the sparse signals is utilized in the present invention, which resolves a problem that costs of capturing a sparse signal are relatively high in an existing wireless communications system, and reduces the costs of capturing a sparse signal.

**Embodiment 4**

This embodiment of the present invention provides a receiver. As shown in FIG. 4, the receiver may include a processor 10, a memory 11, and a system bus 12.

The processor 10 and the memory 11 are connected and implement mutual communication by using the system bus 12.

The processor 10 may be a single-core or multi-core central processing unit, an application-specific integrated circuit, or one or more integrated circuits configured in this embodiment of the present invention.

The memory 11 may be a high-speed RAM (Random Access Memory, random access memory) memory, or a non-volatile memory (non-volatile memory), for example, at least one magnetic disk storage.

The memory 11 is configured to store an execution instruction of a data processing center. Specifically, the execution instruction of the data processing center may include a software program and software code.

Specifically, the processor 10 is configured to: acquire observed data of a first receiver, where the observed data is data that is obtained through sampling performed by the first receiver on a sparse signal of the first receiver according to an observation matrix of the first receiver; configured to determine a shared support set according to a joint sparse feature and the acquired observed data, where the joint sparse feature is that a sparse signal of each receiver of at least two receivers includes at least one support set and at least one shared support set exists between sparse signals of the at least two receivers, where the shared support set is a support set shared between the sparse signals of the at least two receivers, the support set is a non-zero row index set in a matrix of the sparse signal of each receiver, and a backhaul connection is supported between the first receiver and the second receiver; configured to determine a support set of the sparse signal of the first receiver according to the shared support set and the joint sparse feature; and configured to determine the sparse signal of the first receiver according to the shared support set and the support set of the sparse signal of the first receiver.

Further, that the joint sparse feature is that a sparse signal of each receiver of at least two receivers includes at least one support set and at least one shared support set exists between sparse signals of the at least two receivers, where the shared support set is a support set shared between the sparse signals of the at least two receivers, and the support set is a non-zero row index set in a matrix of the sparse signal of each receiver includes:

each receiver includes at least one antenna, and a sparse signal of each antenna of the at least two receivers forms a two-dimensional matrix whose column indicates an antenna sequence number and whose row indicates a signal of each antenna in a same sparse domain represented by a domain value;

the sparse signals of the at least two receivers have at least one shared support set in the two-dimensional matrix, where the shared support set is a shared non-zero row index set of the sparse signals of the at least two receivers in the two-dimensional matrix; and

the sparse signal of each receiver has at least one support set in the two-dimensional matrix, where the support set is an index set that none of row vectors of a same row in the two-dimensional matrix of the sparse signals of the receivers is zero.

Further, the processor 10 is specifically configured to: determine an estimated support set of the sparse signal of the first receiver according to the joint sparse feature and the observed data, and is specifically configured to interchange the estimated support set with an estimated support set of the second receiver, and determine the shared support set according to the joint sparse feature, where the second receiver is another receiver that is in the at least two receivers other than the first receiver and that supports a backhaul connection to the first receiver.

Further, the first receiver obtains the observed data by performing sampling on the sparse signal of the first receiver by using the following formula:

$$Y_i = \Phi_i X_i + N_i \qquad i = 1, \cdots K,$$

where $K$ is a quantity of receivers, and $K \geq 2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$

rows and $N$ columns, where $N$ is a quantity of antennas included in the ith receiver and $N \geq 1$, $M$ is a quantity of rows in the two-dimensional matrix, and $C$ represents a complex number set; $Y_i \in C^{T \times N}$ is a matrix with $T$ rows and $N$ columns, where $T$ is a quantity of observed signals of the ith receiver; $\Phi_i \in C^{T \times M}$ is a matrix with $T$ rows and $M$ columns; and $N_i \in C^{N \times T}$ is a matrix with $N$ rows and $T$ columns.

Further, the receiver may be a base station, or a base station controller, which is not limited in this embodiment of the present invention.

This embodiment of the present invention provides a receiver. After acquiring observed data of the receiver, the receiver determines a shared support set according to a joint sparse feature and the observed data of the receiver; then, the receiver determines a support set of a sparse signal of the receiver according to the shared support set and the joint sparse feature; and finally, the receiver determines the sparse signal of the receiver according to the shared support set and the support set of the sparse signal of the receiver, where the observed data is data that is obtained through sampling performed on the sparse signal of the receiver according to an observation matrix of a first receiver, the joint sparse feature is that a shared support set exists between all sparse signals and at least one support set exists inside each sparse signal, where the support set is a non-zero row index set in a matrix corresponding to each sparse signal, and a non-zero row is a row whose row vector is not zero in the matrix. In the solution, a joint sparse feature inside sparse signals and between the sparse signals is utilized in the present invention, which resolves a problem that costs of capturing a high-dimensional sparse signal are relatively high in an existing wireless communications system, and reduces the costs of capturing a sparse signal.

## Embodiment 5

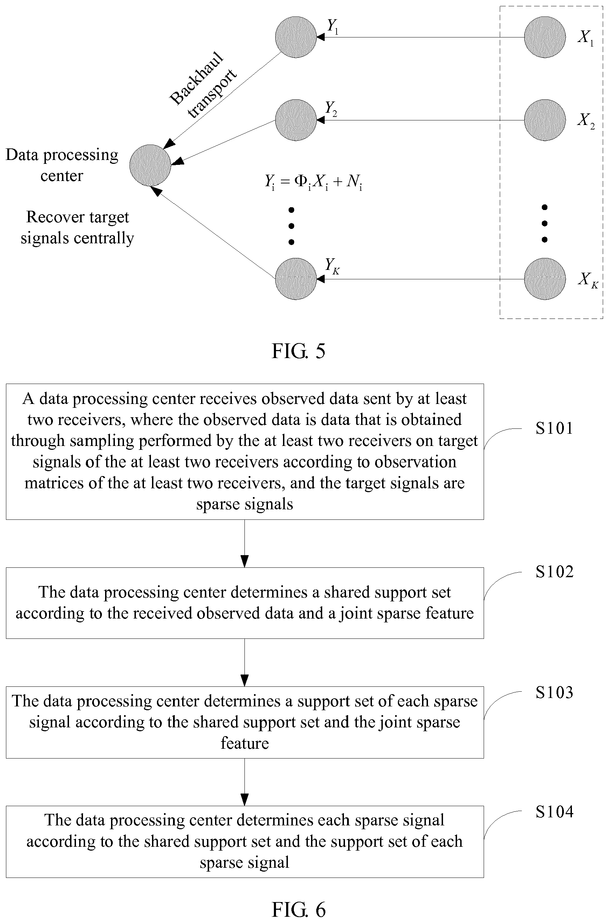

This embodiment of the present invention provides a compressed sensing method, and an application scenario of the method is shown in FIG. 5. An entire wireless communications system includes a data processing center and $K$ ($K \geq 2$) receivers, where $X_i$ is a sparse signal observed by the ith ($1 \leq i \leq K$) receiver; and $Y_i$ is observed data that is related to the sparse signal $X_i$ of the ith receiver and that is obtained by the ith receiver, and $Y_i = \Phi_i X_i + N_i$, where $\Phi_i$ is an observation matrix of the ith receiver, and $N_i$ is observation noise of the ith receiver. The $K$ receivers send the obtained observed data $\{Y_i\}$ separately to the data processing center. In the wireless system, the data processing center recovers sparse signals centrally. As shown in FIG. 6, the method includes:

S101: A data processing center receives observed data sent by at least two receivers, where the observed data is data that is obtained through sampling performed by the at least two receivers on sparse signals of the at least two receivers according to observation matrices of the at least two receivers.

In this embodiment of the present invention, the data processing center may be a central processing unit.

In this embodiment of the present invention, the application scenario is that the data processing center recovers sparse signals centrally; therefore, the data processing center first receives the observed data sent by the at least two receivers.

As a dimension of a target signal in the wireless communications system gradually increases, the target signal generally presents a sparse feature. For example, in an ultra wideband communications system, due to a burst transmission feature of some applications (for a voice service of a mobile user, the user has much idle time), a signal frequency band may be sparsely utilized. Alternatively, in a massive MIMO network, due to limited space scattering, CSI (Channel State Information, channel state information) from a BS (Base Station, base station) to an MS (Mobile Users, mobile user) may present a sparse feature. Alternatively, in a random access communications network, usually, there is a small quantity of real active users. The compressed sensing method provided in this embodiment of the present invention resolves a problem that costs of capturing a high-dimensional target signal in the wireless communications system are high. The method is targeted for a high-dimensional target signal, and therefore, a target signal in this embodiment of the present invention is a sparse signal.

Specifically, the sparse signal refers to a signal that can be expressed by relatively few coefficients in a case in which a relatively small loss is allowed. Exemplarily, a length of a signal $x$ is $N$; if the signal $x$ can be expressed by a linear combination including a set of bases $\Psi^T = [\Psi_1, \Psi_2, \cdots, \Psi_m, \cdots \Psi_M]$ (where $\Psi^T$ represents a transpose of $\Psi$),

$$x = \sum_{k=1}^{N} \Psi_k \alpha_k = \Psi \alpha,$$

where in the formula, $\alpha$ and $x$ are matrices with $N$ rows and one column, and $\Psi$ is a matrix with $N$ rows and $N$ columns. When the signal $x$ has only $K << N$ non-zero coefficients $\alpha_k$ on a basis $\Psi$, the signal $x$ is a sparse signal and is compressible, and $\Psi$ is referred to as a sparse domain of the signal $x$.

It should be noted that, a sparse domain of a sparse signal in this embodiment of the present invention may be a signal frequency band or channel information, which is not limited in this embodiment of the present invention.

Specifically, each receiver in this embodiment of the present invention includes at least one antenna, and a sparse signal of each antenna of the at least two receivers forms a two-dimensional matrix whose column indicates an antenna sequence number and whose row indicates a signal of each antenna in a same sparse domain represented by a domain value. Each receiver obtains observed data of the receiver by performing sampling on a sparse signal of the receiver according to an observation matrix of the receiver by using the following formula:

$$Y_i = \Phi_i X_i + N_i \qquad i = 1, \cdots K ,$$

where $X_i$ is a sparse signal of the ith receiver; $Y_i$ is observed data of $X_i$; $\Phi_i$ is an observation matrix of the ith receiver; $N_i$ is observation noise of the ith receiver; $K$ is a quantity of receivers, and $K \geq 2$; $X_i \in C^{M \times N}$ is a matrix with $M$ rows and $N$ columns, $N$ is a quantity of antennas included in the ith receiver and $N \geq 1$, and $M$ is a quantity of rows in a two-dimensional matrix ($M$ depends on a feature of a sparse signal, for example, if $X_i$ represents channel time domain information, a value of M is determined according to a channel delay and channel sounding precision and may be represented by >>1 (far greater than 1), where when sparsity is sufficiently higher than what is required, M may be a multiple of ten and less than 100; when high sparsity is required, M is greater than 100 or even greater); $Y_i \in C^{T \times N}$ is a matrix with $T$ rows and $N$ columns, $T$ is a quantity of observed signals or referred to as a quantity of collected samples (a value of $T$ is related to both sparsity and $M$; if S represents the sparsity, T is generally represented by an order of magnitude of S*log(M/S)); $\Phi_i \in C^{T \times M}$ is a matrix with $T$ rows and $M$ columns; and $N_i \in C^{N \times T}$ is a matrix of $N$ rows and $T$ columns.

It should be noted that, the observation matrices used by the receivers in this embodiment of the present invention may be the same or may be different, which is not limited in this embodiment of the present invention. Specifically, the observation matrices are determined by the receivers according to channel information of locations of the receivers and other factors.

In addition, the observation matrices of the receivers in this embodiment of the present invention may be the same or may be different, that is, locations of the receivers may be distributed or may be in a same area. In this way, the application scenario in this embodiment of the present invention better conforms to actual application, and the application scenario is not strictly limited.

S102: The data processing center determines a shared support set according to the received observed data and a joint sparse feature.

The joint sparse feature is that a sparse signal of each receiver includes at least one support set and at least one shared support set exists between the sparse signals of the at least two receivers, where the shared support set is a support set shared between the sparse signals of the at least two receivers, and the support set is a non-zero row index set in a matrix of the sparse signal of each receiver.

Specifically, in this embodiment of the present invention, each receiver includes at least one antenna, sparse signals of antennas of the receivers are all sparse signals, and a joint sparse feature is presented between the sparse signals of the at least two receivers and inside the sparse signal of each receiver to some extent.

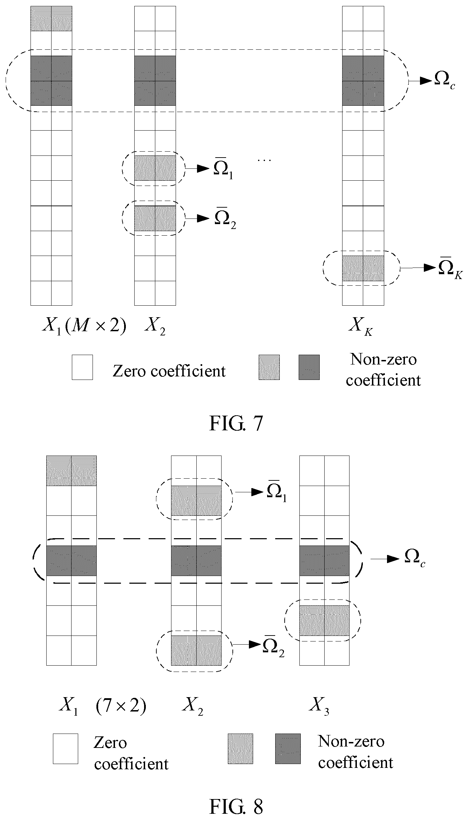

Exemplarily, as shown in FIG. 7, an example in which the wireless communications system includes $K$ receivers and each receiver includes two antennas is used. Sparse signals of each antenna of the $K$ receivers form a two-dimensional matrix whose column indicates an antenna sequence number and whose row indicates a signal of each antenna in a same sparse domain represented by a domain value, where $X_i$ represents a sparse signal of the ith receiver and is a matrix with $M$ rows and two columns. Inside the same matrix $X_i$, none of row vectors is zero, that is, at least one index set $\overline{\Omega}_K$ exists inside the sparse signal of each receiver and is used as a support set of the sparse signal, which means support sets of the sparse signals of all antennas of one receiver are the same. $K$ matrices $X_1, X_2, ...,$ and $X_K$ have one shared support set, that is, there is one index set $\Omega_c$, so that row vectors of $X_1, X_2, ...,$ and $X_K$ are not zero in a row index belonging to $\Omega_c$. In FIG. 3, the sparse signal $X_2$ of the second receiver includes not only a part of the shared support set $\Omega_c$ that exists between the second receiver and another receiver, but also includes two support sets $\overline{\Omega}_1$ and that exist inside the sparse signal $X_2$.

It can be learned from the foregoing that, the joint sparse feature mentioned in this embodiment of the present invention includes the shared support set that exists between the sparse signals of the at least two receivers and the support set that exists inside each sparse signal.

It should be noted that, the joint sparse feature in this embodiment of the present invention is different from a joint sparse feature of a distributed compressed sensing theory in the existing theory field. The joint sparse feature used in the existing distributed compressed sensing theory is applicable only to a single-point wireless communications system, and takes into consideration only that the shared support set exists between the sparse signals of the at least two receivers. The joint sparse feature in this embodiment of the present invention takes into consideration not only that the shared support set exists between the sparse signals of the at least two receivers, but also that the support set exists inside each sparse signal.

In conclusion, the joint sparse feature in this embodiment of the present invention takes into consideration not only the joint sparse feature between different sparse signals, but also the joint sparse feature inside the sparse signal. Compared with the existing joint sparse feature, the joint sparse feature in this embodiment of the present invention is a novel feature that is more applicable to a common scenario in the wireless communications system.

Specifically, after the data processing center receives the observed data sent by the at least two receivers, the data processing center determines the shared support set according to the received observed data and the joint sparse feature.

The data processing center may use any existing feasible signal recovery algorithm to determine the shared support set, which is not limited in this embodiment of the present invention. Exemplarily, the signal recovery algorithm may be an OMP (Orthogonal Matching Pursuit, orthogonal matching pursuit algorithm) algorithm, or may be an optimization algorithm based on an L-1 norm.

Exemplarily, as shown in FIG. 8, the wireless communications system includes three receivers and each receiver includes two antennas. $X_i$ represents a sparse signal of the $i^{th}$ receiver and is a matrix with seven rows and two columns, and a signal matrix including $\{X_1, X_2, X_3\}$ has the joint sparse feature mentioned in this embodiment of the present invention, where a location of a shared support set in the signal matrix including $\{X_1, X_2, X_3\}$ is the fourth row in the matrix. After receiving observed data sent by the three receivers, the data processing center performs processing on observed data of each antenna of each receiver by utilizing the OMP algorithm. The OMP algorithm is an iterative algorithm. In each iteration, the data processing center can find, from observed data of one antenna, a location of one support set of a sparse signal corresponding to the observed data, that is, in each iteration, the data processing center finds an element (that is, a row sequence number) of one support set from the observed data of each antenna. In this example, the data processing center obtains six row sequence numbers according to the OMP algorithm. It is assumed that the six row sequence numbers obtained by the data processing center are {4, 4, 4, 2, 4, 6}. Sparse signals of six antennas include a shared support set, that is, these six sparse signals include a same row sequence number; therefore, the data processing center selects, from these six row sequence numbers, a sequence number 4 with a maximum quantity of repetition times and uses the sequence number 4 as a row sequence number of the shared support set in the matrix of the sparse signals. Further, the data processing center performs $T_1=1$ times of iteration according to a preset quantity $T_1$ of elements in the shared support set, to obtain an entire set of the shared support set.

S103: The data processing center determines a support set of each sparse signal according to the shared support set and the joint sparse feature.

After determining the shared support set, the data processing center determines the support set of each sparse signal according to the shared support set and the joint sparse feature by utilizing any feasible signal recovery algorithm.

Specifically, the sparse signals of the at least two receivers form a two-dimensional matrix whose column indicates an antenna sequence number and whose row indicates a signal of each antenna in a same sparse domain represented by a domain value. The shared support set determined by the data processing center is also a matrix whose column indicates an antenna sequence number and whose row indicates a signal of each antenna in a same sparse domain represented by a domain value. By using the shared support set, the data processing center can obtain a signal corresponding to the sparse signal of each receiver from the shared support set according to columns; therefore, the data processing center can determine the support set of each sparse signal according to the shared support set and the joint sparse feature.

Exemplarily, as shown in FIG. 8, after the data processing center determines that an element of the shared support set $\Omega_c$ of $\{X_1, X_2, X_3\}$ is {4}, the data processing center performs joint processing on the observed data of all antennas of each receiver by utilizing a feature that the support sets of the sparse signals of all the antennas of each receiver are the same. For example, the data processing center puts the element {4} of the shared support set $\Omega_c$ into a support set of $X_2$, which is equivalent to that $T_1$ times of iteration have been performed on the observed data of the second receiver by utilizing the OMP algorithm. The data processing center continues to perform ($T_{2i} - T_1=2$) times of iterations according to a preset total quantity $T_{2i}=3$ of elements of the support set of $X_2$, to obtain support sets $\{\overline{\Omega}_1, \overline{\Omega}_2\}$ of $X_2$.

S104: The data processing center determines each sparse signal according to the shared support set and the support set of each sparse signal.

In this embodiment of the present invention, at least one support set exists inside the sparse signal of each receiver, and the shared support set exists between the sparse signals of the at least two receivers. After determining the support set of each sparse signal, the data processing center can determine each sparse signal according to the determined support set of each sparse signal and the determined shared support set.

For example, as shown in FIG. 8, after the data processing center determines that the shared support set of $\{X_1, X_2, X_3\}$ is $\Omega_c$ and the support sets of the sparse signal $X_2$ are $\overline{\Omega}_1$ and $\overline{\Omega}_2$, the data processing center obtains a signal corresponding to the sparse signal of the second receiver from the shared support set, $\overline{\Omega}_1$ and $\overline{\Omega}_2$ according to the columns. Because a sparse signal is mainly included a shared support set and a support set, the data processing center may obtain the sparse signal $X_2$ by using the signal recovery algorithm in the existing compressed sensing method.

In conclusion, during a sparse signal recovery process in this embodiment of the present invention, the joint sparse feature between the sparse signals and inside the sparse signals is utilized, which can significantly reduce a sampling rate of each receiver or a data volume of observed data of each receiver. The observed data of each receiver is data that is obtained through sampling performed on the sparse signal, and the data volume of the observed data acquired by each receiver is relatively small. In this way, each receiver sends the observed data of each receiver to the data processing center, which reduces load of backhaul from the receiver to the data processing center, lowers complexity of computation processing of each receiver, and also reduces a processing delay of each receiver correspondingly.

This embodiment of the present invention provides a compressed sensing method. After a data processing center receives observed data sent by at least one receiver, the data processing center determines a shared support set according to all observed data and a joint sparse feature; after determining the shared support set, the data processing center determines a support set of each sparse signal according to the shared support set and the joint sparse feature; and finally, the data processing center determines each sparse signal according to the shared support set and the support set of each sparse signal, where the observed data is data that is obtained through sampling performed by each receiver on a sparse signal of the receiver according to an observation matrix of the receiver, and the joint sparse feature is that a shared support set exists between all sparse signals and at least one support set exists inside each sparse signal, where the support set is a non-zero row index set in a matrix corresponding to each sparse signal, and a non-zero row is a row whose row vector is not zero in the matrix. In the solution, a joint sparse feature inside sparse signals and between the sparse signals is utilized in the present invention, which resolves a problem that costs of capturing a sparse signal are relatively high in an existing wireless communications system, and reduces the costs of capturing a sparse signal.

**Embodiment 6**

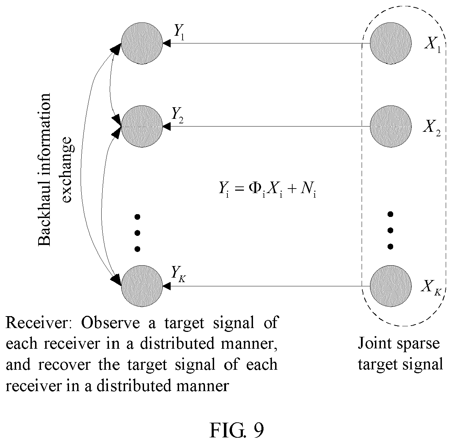

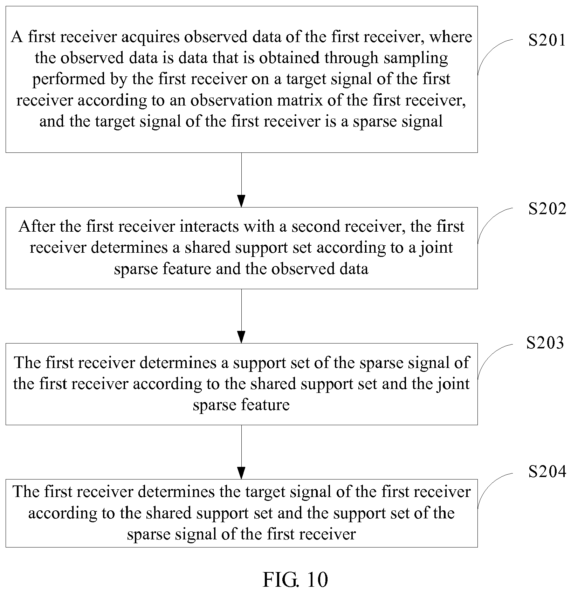

This embodiment of the present invention provides a compressed sensing method, and an application scenario of the method is shown in FIG. 9. An entire wireless communications system includes $K$ ($K \geq 2$) receivers, and a backhaul connection is supported between different receivers, so that information exchange can be implemented between the receivers. $X_i$ is a sparse signal observed by the i$^{th}$ ($1 \leq i \leq K$) receiver; and $Y_i$ is observed data that is related to the sparse signal $X_i$ of the i$^{th}$ receiver and that is obtained by the i$^{th}$ receiver, and $Y_i = \Phi_i X_i + N_i$, where $\Phi_i$ is an observation matrix of the i$^{th}$ receiver, and $N_i$ is observation noise of the i$^{th}$ receiver. In the wireless system, each receiver obtains observed data of the receiver, and independently recovers a sparse signal of the receiver by means of information exchange. As shown in FIG. 10, the method includes:

S201: A first receiver acquires observed data of the first receiver, where the observed data is data that is obtained through sampling performed by the first receiver on a sparse signal of the first receiver according to an observation matrix of the first receiver.

This embodiment of the present invention is executed by the first receiver, where the first receiver is any receiver in the wireless communications system and is not limited in this embodiment of the present invention.

The first receiver in this embodiment of the present invention may be a base station, or may be a base station controller.

Because the compressed sensing method provided in this embodiment of the present invention is applicable to a scenario in which each receiver obtains the observed data of the receiver and independently recovers the sparse signal of the receiver by means of information exchange, the first receiver first obtains the observed data of the first receiver.

Specifically, a process of acquiring, by the first receiver, the observed data of the first receiver is identical with a process of obtaining the observed data through sampling performed by the at least two receivers on the sparse signals of the at least two receivers according to the observation matrices of the at least two receivers in S101 of Embodiment 1, and details are not described again.

S202: The first receiver determines a shared support set according to a joint sparse feature and the observed data.

Specifically, the first receiver first determines an estimated support set of the sparse signal of the first receiver according to the joint sparse feature and the observed data of the first receiver; then, the first receiver interchanges, through a backhaul connection, the estimated support set of the first receiver with an estimated support set of a receiver that is in the at least two receivers other than the first receiver and that supports the backhaul connection to the first receiver; and finally, the first receiver determines the shared support set according to the joint sparse feature.

That the first receiver interchanges, through a backhaul connection, the estimated support set with an estimated support set of a receiver that is in the at least two receivers other than the first receiver and that supports the backhaul connection to the first receiver may be: the first receiver interchanges the estimated support set of the first receiver with estimated support sets of all receivers except the first receiver one by one, or the first receiver interchanges, in an information center, the estimated support set of the first receiver with estimated support sets of all receivers except the first receiver, which is not limited in this embodiment of the present invention.

It should be noted that, the information center mentioned herein may be a simple data exchange center and does not have a data processing capability, and data in the information center may only be an estimated support set of each receiver, where each estimated support set is represented only by one bit (0 or 1). The data processing center in Embodiment 1 may perform processing on all observed data, where each piece of the observed data is a real number and generally can be represented precisely by over 12 bits.

The first receiver may use any feasible signal recovery algorithm to determine the shared support set, which is not limited in this embodiment of the present invention. Exemplarily, the signal recovery algorithm may be an OMP (Orthogonal Matching Pursuit, orthogonal matching pursuit algorithm) algorithm, or may be an optimization algorithm based on an l-1 norm.

Exemplarily, as shown in FIG. 8, the wireless communications system includes three receivers and each receiver includes two antennas, where $X_i$ represents a sparse signal of the $i^{th}$ receiver and is a matrix with seven rows and two columns, and a signal matrix including {$X_1$,

$X_2, X_3$} has the joint sparse feature mentioned in this embodiment of the present invention. The first receiver performs, according to the OMP algorithm, joint processing on observed data of all antennas of the first receiver by utilizing a feature that support sets of sparse signals of all the antennas of the first receiver are the same. The OMP algorithm is an iterative algorithm. In each iteration, the first receiver can find, from observed data of one antenna of the first receiver, a location of one support set of a sparse signal corresponding to the observed data, that is, in each iteration, the first receiver finds an element (that is, a row sequence number) of one support set from the observed data of each antenna. After one time of iteration is performed, the first receiver interchanges an element of the estimated support set with a row sequence number of an estimated support set of the second receiver and a row sequence number of an estimated support set of the third receiver through a backhaul connection. Sparse signals of these three receivers include a shared support set, that is, the sparse signals of the three receivers include a same row sequence number; therefore, after the first receiver obtains estimated support sets of the other receivers that support a backhaul connection to the first receiver, the first receiver selects, according to a feature that the joint sparse feature includes a shared support set, an element ({4} in this example) with a maximum quantity of repetition times and uses the element as an element of the shared support set. The first receiver repeats, according to a preset quantity $T_1$ of elements of the shared support set, the foregoing step for $T_1$ times, to obtain the shared support set.

S203: The first receiver determines a support set of the sparse signal of the first receiver according to the shared support set and the joint sparse feature.

After determining the shared support set, the first receiver determines the support set of the sparse signal of the first receiver according to the shared support set and the joint sparse feature by utilizing any feasible signal recovery algorithm.

Specifically, all sparse signals form a two-dimensional matrix whose column indicates an antenna sequence number and whose row indicates a signal of each antenna in a same sparse domain represented by a domain value. The shared support set determined by the first receiver is also a matrix whose column indicates an antenna sequence number and whose row indicates a signal of each antenna in a same sparse domain represented by a same domain value. The first receiver may determine the support set of the sparse signal of the first receiver according to the shared support set and the joint sparse feature. The method is the same as the method of determining, by the data processing center, the support set of each sparse signal in S103 of Embodiment 1, and details are not described herein again.

S204: The first receiver determines the sparse signal of the first receiver according to the shared support set and the support set of the sparse signal of the first receiver.

In this embodiment of the present invention, at least one support set exists inside the sparse signal of each receiver, and a shared support set exists between all the sparse signals. After determining the support set of the sparse signal of the first receiver, the first receiver determines the sparse signal of the first receiver according to the determined support set of the sparse signal and the determined shared support set.

In conclusion, during a sparse signal recovery process in this embodiment of the present invention, the joint sparse feature between the sparse signals and inside the sparse signals is utilized, which can significantly reduce a sampling rate of each receiver or a data volume of observed data of each receiver. Each receiver recovers each sparse signal in a distributed manner, which delivers high flexibility and high robustness. In addition, only estimated support set information of a sparse signal needs to be exchanged between receivers, and other information does not need to be exchanged, so that load of backhaul between the receivers is relatively small.

This embodiment of the present invention provides a compressed sensing method. After acquiring observed data of a first receiver, the first receiver determines a shared support set according to a joint sparse feature and the observed data of the first receiver; then, the first receiver determines a support set of a sparse signal of the first receiver according to the shared support set and the joint sparse feature; and finally, the first receiver determines the sparse signal of the first receiver according to the shared support set and the support set of the sparse signal of the first receiver, where the observed data is data that is obtained through sampling performed by the first receiver on the sparse signal of the first receiver according to an observation matrix of the first receiver, and the joint sparse feature is that a shared support set exists between all sparse signals and at least one support set exists inside each sparse signal, where the support set is a non-zero row index set in a matrix corresponding to each sparse signal, and a non-zero row is a row whose row vector is not zero in the matrix. In the solution, a joint sparse feature inside sparse signals and between the sparse signals is utilized in the present invention, which resolves a problem that costs of capturing a high-dimensional sparse signal are relatively high in an existing wireless communications system, and reduces the costs of capturing a sparse signal.

A joint sparse feature involved in the compressed sensing method provided in the present invention is widely applicable to a wireless communications scenario. According to the method, no matter in a scenario in which all observed data is combined for jointly recovering a sparse signal, or in a scenario in which a sparse signal of each receiver is independently recovered by using observed data of each receiver, that is, no matter the application scenario is the application scenario of Embodiment 1 or the application scenario of Embodiment 2, a joint sparse feature of the sparse signals needs to be utilized during a sparse signal recovery process to first recover a shared support set of all sparse signals, then recover a support set of each sparse signal, and finally recover each independent sparse signal. During the whole sparse signal recovery process, the joint sparse feature and a compressed sensing theory are applied, which significantly reduces costs of acquiring a sparse signal.

It may be clearly understood by a person skilled in the art that, for the purpose of convenient and brief description, division of the foregoing function modules is taken as an example for illustration. In actual application, the foregoing functions can be allocated to different function modules and implemented according to a requirement, that is, an inner structure of an apparatus is divided into different function modules to implement all or some of the functions described above. For a detailed working process of the foregoing apparatus, reference may be made to a corresponding process in the foregoing method embodiments, and details are not described herein again.

In the several embodiments provided in the present application, it should be understood that the disclosed apparatus and method may be implemented in other manners. For example, the apparatus embodiment described above is merely exemplary.

The units described as separate parts may or may not be physically separate, and parts displayed as units may be one or more physical units, may be located in one place, or may be distributed on different places. Some or all of the units may be selected according to actual needs to achieve the objectives of the solutions of the embodiments.

In addition, functional units in the embodiments of the present invention may be integrated into one processing unit, or each of the units may exist alone physically, or two or more units are integrated into one unit. The integrated unit may be implemented in a form of hardware, or may be implemented in a form of a software functional unit.

When the integrated unit is implemented in the form of a software functional unit and sold or used as an independent product, the integrated unit may be stored in a readable storage medium. Based on such an understanding, the technical solutions of the present invention essentially, or the part contributing to the prior art, or all or some of the technical solutions may be implemented in the form of a software product. The software product is stored in a storage medium and includes several instructions for instructing a device (which may be a single-chip microcomputer, a chip or the like) or a processor (processor) to perform all or some of the steps of the methods described in the embodiments of the present invention. The foregoing storage medium includes: any medium that can store program code, such as a USB flash drive, a portable hard disk, a read-only memory (ROM, Read-Only Memory), a random access memory, a magnetic disk, or an optical disc.

The foregoing descriptions are merely specific implementation manners of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

**Claims**

1. A data processing center, comprising:

   a receiving unit, configured to receive observed data sent by at least two receivers, wherein the observed data is data that is obtained through sampling performed by the at least two receivers on sparse signals of the at least two receivers according to observation matrices of the at least two receivers; and
   a determining unit, configured to: determine a shared support set according to the observed data received by the receiving unit and a joint sparse feature, wherein the joint sparse feature is that a sparse signal of each receiver comprises at least one support set and at least one shared support set exists between the sparse signals of the at least two receivers, wherein the shared support set is a support set shared between the sparse signals of the at least two receivers, and the support set is a non-zero row index set in a matrix of the sparse signal of each receiver; configured to determine a support set of each sparse signal according to the shared support set and the joint sparse feature; and configured to determine each sparse signal according to the shared support set and the support set of each sparse signal.

2. The data processing center according to claim 1, wherein that the joint sparse feature is that a sparse signal of each receiver comprises at least one support set and at least one shared support set exists between the sparse signals of the at least two receivers, wherein the shared support set is a support set shared between the sparse signals of the at least two receivers, and the support set is a non-zero row index set in a matrix of the sparse signal of each receiver comprises:

each receiver comprises at least one antenna, and a sparse signal of each antenna of the at least two receivers forms a two-dimensional matrix whose column indicates an antenna sequence number and whose row indicates a signal of each antenna in a same sparse domain represented by a domain value;
the sparse signals of the at least two receivers have at least one shared support set in the two-dimensional matrix, wherein the shared support set is a shared non-zero row index set of the sparse signals of the at least two receivers in the two-dimensional matrix; and
the sparse signal of each receiver has at least one support set in the two-dimensional matrix, wherein the support set is an index set that none of row vectors of a same row in the two-dimensional matrix of the sparse signals of the receivers is zero.

3. The data processing center according to claim 1, wherein the at least two receivers obtain the observed data by performing sampling on the sparse signals of the at least two receivers by using the following formula:

$$Y_i = \Phi_i X_i + N_i \qquad i = 1, \cdots K ,$$

wherein $K$ is a quantity of receivers, and $K \geq 2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$ rows and $N$ columns, wherein $N$ is a quantity of antennas comprised in the $i^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, wherein $T$ is a quantity of observed signals of the $i^{th}$ receiver; $\Phi_i \in C^{T \times M}$ is a matrix with $T$ rows and $M$ columns; and $N_i \in C^{N \times T}$ is a matrix with $N$ rows and $T$ columns.

4. A receiver, comprising:

an acquiring unit, configured to acquire observed data of a first receiver, wherein the observed data is data that is obtained through sampling performed by the first receiver on a sparse signal of the first receiver according to an observation matrix of the first receiver; and
a determining unit, configured to: determine a shared support set according to a joint sparse feature and the observed data acquired by the acquiring unit, wherein the joint sparse feature is that a sparse signal of each receiver of at least two receivers comprises at least one support set and at least one shared support set exists between sparse signals of the at least two receivers, wherein the shared support set is a support set shared between the sparse signals of the at least two receivers, the support set is a non-zero row index set in a matrix of the sparse signal of each receiver, and a backhaul connection is supported between the first receiver and the second receiver; configured to determine a support set of the sparse signal of the first receiver according to the shared support set and the joint sparse feature; and configured to determine the sparse signal of the first receiver according to the shared support set and the support set of the sparse signal of the first receiver.

5. The receiver according to claim 4, wherein that the joint sparse feature is that a sparse signal of each receiver of at least two receivers comprises at least one support set and at least one shared support set exists between sparse signals of the at least two receivers, wherein the shared support set is a support set shared between the sparse signals of the at least two receivers, and the support set is a non-zero row index set in a matrix of the sparse signal of each receiver comprises:

each receiver comprises at least one antenna, and a sparse signal of each antenna of the at least two receivers forms a two-dimensional matrix whose column indicates an antenna sequence number and whose row indicates a signal of each antenna in a same sparse domain represented by a domain value;
the sparse signals of the at least two receivers have at least one shared support set in the two-dimensional matrix, wherein the shared support set is a shared non-zero row index set of the sparse signals of the at least two receivers in the two-dimensional matrix; and
the sparse signal of each receiver has at least one support set in the two-dimensional matrix, wherein the support set is an index set that none of row vectors of a same row in the two-dimensional matrix of the sparse signals of the receivers is zero.

6. The receiver according to claim 5, wherein the determining unit is specifically configured to: determine an estimated support set of the sparse signal of the first receiver according to the joint sparse feature and the observed data, and is specifically configured to interchange the estimated support set with an estimated support set of the second receiver, and determine the shared support set according to the joint sparse feature, wherein the second receiver is another receiver that is in the at least two receivers other than the first receiver and that supports a backhaul connection to the first receiver.

7. The receiver according to claim 5, wherein the first receiver obtains the observed data by performing sampling on the sparse signal of the first receiver by using the following formula:

$$Y_i = \Phi_i X_i + N_i \qquad i = 1, \cdots K,$$

wherein $K$ is a quantity of receivers, and $K \geq 2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$ rows and $N$ columns, wherein $N$ is a quantity of antennas comprised in the $i^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, wherein $T$ is a quantity of observed signals of the $i^{th}$ receiver; $\Phi_i \in C^{T \times M}$ is a matrix with $T$ rows and $M$ columns; and $N_i \in C^{N \times T}$ is a matrix with $N$ rows and $T$ columns.

8. A data processing center, comprising:

a receiver, configured to receive observed data sent by at least two receivers, wherein the observed data is data that is obtained through sampling performed by the at least two receivers on sparse signals of the at least two receivers according to observation matrices of the at least two receivers; and
a processor, configured to: determine a shared support set according to the observed data received by the receiver and a joint sparse feature, wherein the joint sparse feature is that a sparse signal of each receiver comprises at least one support set and at least one shared support set exists between the sparse signals of the at least two receivers, wherein the shared support set is a support set shared between the sparse signals of the at least two receivers, and the support set is a non-zero row index set in a matrix of the sparse signal of each receiver; configured to determine a support set of each sparse signal according to the shared support set and the joint sparse feature; and configured to determine each sparse signal according to the shared support set and the support set of each sparse signal.

9. The data processing center according to claim 8, wherein that the joint sparse feature is that a sparse signal of each receiver comprises at least one support set and at least one shared support set exists between the sparse signals of the at least two receivers, wherein the shared support set is a support set shared between the sparse signals of the at least two receivers, and the support set is a non-zero row index set in a matrix of the sparse signal of each receiver comprises:

each receiver comprises at least one antenna, and a sparse signal of each antenna of the at least two receivers forms a two-dimensional matrix whose column indicates an antenna sequence number and whose row indicates a signal of each antenna in a same sparse domain represented by a domain value;
the sparse signals of the at least two receivers have at least one shared support set in the two-dimensional matrix, wherein the shared support set is a shared non-zero row index set of the sparse signals of the at least two receivers in the two-dimensional matrix; and
the sparse signal of each receiver has at least one support set in the two-dimensional matrix, wherein the support set is an index set that none of row vectors of a same row in the two-dimensional matrix of the sparse signals of the receivers is zero.

10. The data processing center according to claim 8, wherein the at least two receivers obtain the observed data by performing sampling on the sparse signals of the at least two receivers by using the following formula:

$$Y_i = \Phi_i X_i + N_i \qquad i = 1, \cdots K,$$

wherein $K$ is a quantity of receivers, and $K \geq 2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$ rows and $N$ columns, wherein $N$ is a quantity of antennas comprised in the $i^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, wherein $T$ is a quantity of observed signals of the $i^{th}$ receiver; $\Phi_i \in C^{T \times M}$ is a matrix with $T$ rows and $M$ columns; and $N_i \in C^{N \times T}$ is a matrix with $N$ rows and *T* columns.

11. The data processing center according to any one of claims 8 to 10, wherein
the data processing center comprises a central processing unit.

12. A receiver, comprising:

a processor, configured to: acquire observed data of a first receiver, wherein the observed data is data that is obtained through sampling performed by the first receiver on a sparse signal of the first receiver according to an observation matrix of the first receiver; configured to determine a shared support set according to a joint sparse feature and the acquired observed data, wherein the joint sparse feature is that a sparse signal of each receiver of at least two receivers comprises at least one support set and at least one shared support set exists between sparse signals of the at least two receivers, wherein the shared support set is a support set shared between the sparse signals of the at least two receivers, the support set is a non-zero row index set in a matrix of the sparse signal of each receiver, and a backhaul connection is supported between the first receiver and the second receiver; configured to determine a support set of the sparse signal of the first receiver according to the shared support set and the joint sparse feature; and configured to determine the sparse signal of the first receiver according to the shared support set and the support set of the sparse signal of the first receiver.

13. The receiver according to claim 12, wherein that the joint sparse feature is that a sparse signal of each receiver of at least two receivers comprises at least one support set and at least one shared support set exists between sparse signals of the at least two receivers, wherein the shared support set is a support set shared between the sparse signals of the at least two receivers, and the support set is a non-zero row index set in a matrix of the sparse signal of each receiver comprises:

each receiver comprises at least one antenna, and a sparse signal of each antenna of the at least two receivers forms a two-dimensional matrix whose column indicates an antenna sequence number and whose row indicates a signal of each antenna in a same sparse domain represented by a domain value; the sparse signals of the at least two receivers have at least one shared support set in the two-dimensional matrix, wherein the shared support set is a shared non-zero row index set of the sparse signals of the at least two receivers in the two-dimensional matrix; and
the sparse signal of each receiver has at least one support set in the two-dimensional matrix, wherein the support set is an index set that none of row vectors of a same row in the two-dimensional matrix of the sparse signals of the receivers is zero.

14. The receiver according to claim 13, wherein the processor is specifically configured to: determine an estimated support set of the sparse signal of the first receiver according to the joint sparse feature and the observed data, and is specifically configured to interchange the estimated support set with an estimated support set of the second receiver, and determine the shared support set according to the joint sparse feature, wherein the second receiver is another receiver that is in the at least two receivers other than the first receiver and that supports a backhaul connection to the first receiver.

15. The receiver according to claim 13, wherein the first receiver obtains the observed data by performing sampling on the sparse signal of the first receiver by using the following formula:

$$Y_i = \Phi_i X_i + N_i \qquad i = 1, \cdots K ,$$

wherein $K$ is a quantity of receivers, and $K \geq 2$; $X_i$ is a sparse signal of the i$^{th}$ receiver; $Y_i$ is observed data of $X_i$; $\Phi_i$ is an observation matrix of the i$^{th}$ receiver; $N_i$ is observation noise of the i$^{th}$ receiver; $X_i \in C^{M \times N}$ is a matrix with $M$ rows and $N$ columns, wherein $N$ is a quantity of antennas comprised in the i$^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, wherein $T$ is a quantity of observed signals of the i$^{th}$ receiver; $\Phi_i \in C^{T \times M}$ is a matrix with $T$ rows and $M$ columns; and $N_i \in C^{N \times T}$ is a matrix with $N$ rows and $T$ columns.

16. The receiver according to any one of claims 12 to 15, wherein
the receiver comprises a base station or a base station controller.

17. A compressed sensing method, comprising:

receiving observed data sent by at least two receivers, wherein the observed data is data that is obtained through sampling performed by the at least two receivers on sparse signals of the at least two receivers according to observation matrices of the at least two receivers;

determining a shared support set according to the received observed data and a joint sparse feature, wherein the joint sparse feature is that a sparse signal of each receiver comprises at least one support set and at least one shared support set exists between the sparse signals of the at least two receivers, wherein the shared support set is a support set shared between the sparse signals of the at least two receivers, and the support set is a non-zero row index set in a matrix of the sparse signal of each receiver; determining a support set of each sparse signal according to the shared support set and the joint sparse feature; and determining each sparse signal according to the shared support set and the support set of each sparse signal.

18. The compressed sensing method according to claim 17, wherein that the joint sparse feature is that a sparse signal of each receiver comprises at least one support set and at least one shared support set exists between the sparse signals of the at least two receivers, wherein the shared support set is a support set shared between the sparse signals of the at least two receivers, and the support set is a non-zero row index set in a matrix of the sparse signal of each receiver comprises:

each receiver comprises at least one antenna, and a sparse signal of each antenna of the at least two receivers forms a two-dimensional matrix whose column indicates an antenna sequence number and whose row indicates a signal of each antenna in a same sparse domain represented by a domain value; the sparse signals of the at least two receivers have at least one shared support set in the two-dimensional matrix, wherein the shared support set is a shared non-zero row index set of the sparse signals of the at least two receivers in the two-dimensional matrix; and the sparse signal of each receiver has at least one support set in the two-dimensional matrix, wherein the support set is an index set that none of row vectors of a same row in the two-dimensional matrix of the sparse signals of the receivers is zero.

19. The compressed sensing method according to claim 17, wherein the at least two receivers obtain the observed data by performing sampling on the sparse signals of the at least two receivers by using the following formula:

$$Y_i = \Phi_i X_i + N_i \qquad i = 1, \cdots K,$$

wherein $K$ is a quantity of receivers, and $K \geq 2$; $X_i$ is a sparse signal of the ith receiver; $Y_i$ is observed data of $X_i$; $\Phi_i$ is an observation matrix of the ith receiver; $N_i$ is observation noise of the ith receiver; $X_i \in C^{M \times N}$ is a matrix with $M$ rows and $N$ columns, wherein $N$ is a quantity of antennas comprised in the ith receiver and $N \geq 1$, $M$ is a quantity of rows in the two-dimensional matrix, and $C$ represents a complex number set; $Y_i \in C^{T \times N}$ is a matrix with $T$ rows and $N$ columns, wherein $T$ is a quantity of observed signals of the ith receiver; $\Phi_i \in C^{T \times M}$ is a matrix with $T$ rows and $M$ columns; and $N_i \in C^{N \times T}$ is a matrix with $N$ rows and $T$ columns.

20. A compressed sensing method, comprising:

acquiring observed data of a first receiver, wherein the observed data is data that is obtained through sampling performed by the first receiver on a sparse signal of the first receiver according to an observation matrix of the first receiver; determining a shared support set according to a joint sparse feature and the observed data, wherein the joint sparse feature is that a sparse signal of each receiver of at least two receivers comprises at least one support set and at least one shared support set exists between sparse signals of the at least two receivers, wherein the shared support set is a support set shared between the sparse signals of the at least two receivers, the support set is a non-zero row index set in a matrix of the sparse signal of each receiver, and a backhaul connection is supported between the first receiver and the second receiver; determining a support set of the sparse signal of the first receiver according to the shared support set and the joint sparse feature; and determining the sparse signal of the first receiver according to the shared support set and the support set of the sparse signal of the first receiver.

21. The compressed sensing method according to claim 20, wherein that the joint sparse feature is that a sparse signal of each receiver of at least two receivers comprises at least one support set and at least one shared support set exists between sparse signals of the at least two receivers, wherein the shared support set is a support set shared between the sparse signals of the at least two receivers, and the support set is a non-zero row index set in a matrix of the sparse signal of each receiver comprises:

each receiver comprises at least one antenna, and a sparse signal of each antenna of the at least two receivers forms a two-dimensional matrix whose column indicates an antenna sequence number and whose row indicates a signal of each antenna in a same sparse domain represented by a domain value;

the sparse signals of the at least two receivers have at least one shared support set in the two-dimensional matrix, wherein the shared support set is a shared non-zero row index set of the sparse signals of the at least two receivers in the two-dimensional matrix; and

the sparse signal of each receiver has at least one support set in the two-dimensional matrix, wherein the support set is an index set that none of row vectors of a same row in the two-dimensional matrix of the sparse signals of the receivers is zero.

22. The compressed sensing method according to claim 21, wherein the determining a shared support set according to a joint sparse feature and the observed data specifically comprises:

determining an estimated support set of the sparse signal of the first receiver according to the joint sparse feature and the observed data; and

interchanging the estimated support set with an estimated support set of the second receiver, and determining the shared support set according to the joint sparse feature, wherein the second receiver is another receiver that is in the at least two receivers other than the first receiver and that supports a backhaul connection to the first receiver.

23. The compressed sensing method according to claim 20, wherein the first receiver obtains the observed data by performing sampling on the sparse signal of the first receiver by using the following formula:

$$Y_i = \Phi_i X_i + N_i \qquad i = 1, \cdots K,$$

wherein $K$ is a quantity of receivers, and $K \geq 2$; $X_i$ is a sparse signal of the $i^{th}$ receiver; $Y_i$ is observed data of $X_i$; $\Phi_i$ is an observation matrix of the $i^{th}$ receiver; $N_i$ is observation noise of the $i^{th}$ receiver; $X_i \in C^{M \times N}$ is a matrix with $M$ rows and $N$ columns, wherein $N$ is a quantity of antennas comprised in the $i^{th}$ receiver and $N \geq 1$, $M$ is a quantity of rows in the two-dimensional matrix, and $C$ represents a complex number set; $Y_i \in C^{T \times N}$ is a matrix with $T$ rows and $N$ columns, wherein $T$ is a quantity of observed signals of the $i^{th}$ receiver; $\Phi_i \in C^{T \times M}$ is a matrix with $T$ rows and $M$ columns; and $N_i \in C^{N \times T}$ is a matrix with $N$ rows and $T$ columns.

Data processing center 1

Receiving unit 10

Determining unit 11

FIG. 1

Receiver 1

Acquiring unit 10

Determining unit 11

FIG. 2

Data processing center

Receiver 10

Memory 12

Software program

Software code

13

11 Processor

FIG. 3

Receiver

Processor 10

Memory 11

Software program

Software code

12

FIG. 4

Data processing center

Recover target signals centrally

$Y_i = \Phi_i X_i + N_i$

FIG. 5

| A data processing center receives observed data sent by at least two receivers, where the observed data is data that is obtained through sampling performed by the at least two receivers on target signals of the at least two receivers according to observation matrices of the at least two receivers, and the target signals are sparse signals | S101 |

| The data processing center determines a shared support set according to the received observed data and a joint sparse feature | S102 |

| The data processing center determines a support set of each sparse signal according to the shared support set and the joint sparse feature | S103 |

| The data processing center determines each sparse signal according to the shared support set and the support set of each sparse signal | S104 |

FIG. 6

$X_1(M \times 2)$   $X_2$   $X_K$

$\square$ Zero coefficient   Non-zero coefficient

FIG. 7

$X_1$  $(7 \times 2)$   $X_2$   $X_3$

$\square$ Zero coefficient   Non-zero coefficient

FIG. 8

$$Y_i = \Phi_i X_i + N_i$$

Backhaul information exchange

Receiver: Observe a target signal of each receiver in a distributed manner, and recover the target signal of each receiver in a distributed manner

Joint sparse target signal

FIG. 9

A first receiver acquires observed data of the first receiver, where the observed data is data that is obtained through sampling performed by the first receiver on a target signal of the first receiver according to an observation matrix of the first receiver, and the target signal of the first receiver is a sparse signal — S201

After the first receiver interacts with a second receiver, the first receiver determines a shared support set according to a joint sparse feature and the observed data — S202

The first receiver determines a support set of the sparse signal of the first receiver according to the shared support set and the joint sparse feature — S203

The first receiver determines the target signal of the first receiver according to the shared support set and the support set of the sparse signal of the first receiver — S204

FIG. 10

EP 3 133 850 A1

# INTERNATIONAL SEARCH REPORT

| | International application No. |
|---|---|
| | PCT/CN2014/076688 |

## A. CLASSIFICATION OF SUBJECT MATTER

H04W 8/22 (2009.01) i

According to International Patent Classification (IPC) or to both national classification and IPC

## B. FIELDS SEARCHED

Minimum documentation searched (classification system followed by classification symbols)

H04B; H04L; H04W; H03M

Documentation searched other than minimum documentation to the extent that such documents are included in the fields searched

Electronic data base consulted during the international search (name of data base and, where practicable, search terms used)

CPRSABS, VEN, CNKI: support set, support, set, compress, sense, sparse, index

## C. DOCUMENTS CONSIDERED TO BE RELEVANT

| Category* | Citation of document, with indication, where appropriate, of the relevant passages | Relevant to claim No. |
|---|---|---|
| A | CN 103476040 A (CHONGQING UNIVERSITY OF POSTS AND TELECOMMUNICATIONS), 25 December 2013 (25.12.2013), the whole document | 1-23 |
| A | CN 102970044 A (NANKAI UNIVERSITY), 13 March 2013 (13.03.2013), the whole document | 1-23 |
| A | CN 102045118 A (TSINGHUA UNIVERSITY), 04 May 2011 (04.05.2011), the whole document | 1-23 |

☐ Further documents are listed in the continuation of Box C.  ☒ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 16 January 2015 (16.01.2015) | **06 February 2015 (06.02.2015)** |

| Name and mailing address of the ISA/CN: State Intellectual Property Office of the P. R. China No. 6, Xitucheng Road, Jimenqiao Haidian District, Beijing 100088, China Facsimile No.: (86-10) 62019451 | Authorized officer **TANG, Mingming** Telephone No.: (86-10) **62411353** |

Form PCT/ISA/210 (second sheet) (July 2009)

## INTERNATIONAL SEARCH REPORT
### Information on patent family members

| International application No. |
| --- |
| **PCT/CN2014/076688** |

| Patent Documents referred in the Report | Publication Date | Patent Family | Publication Date |
| --- | --- | --- | --- |
| CN 103476040 A | 25 December 2013 | None | |
| CN 102970044 A | 13 March 2013 | None | |
| CN 102045118 A | 04 May 2011 | CN 102045118 B | 18 June 2014 |

Form PCT/ISA/210 (patent family annex) (July 2009)